# EUROPEAN PATENT SPECIFICATION

(11) **EP 3 277 065 B1**
(45) Date of publication and mention of the grant of the patent: **11.08.2021**
(21) Application number: 16771993.9
(22) Date of filing: 25.02.2016
(51) Int. Cl.: H05K 3/46, H01L 23/12, H01L 27/14, H05K 1/02, H01L 23/538, H01L 27/146

(54) **IMAGING COMPONENT, AND IMAGING MODULE PROVIDED WITH SAME**
BILDGEBUNGSKOMPONENTE UND BILDGEBUNGSMODUL DAMIT
COMPOSANT D'IMAGERIE ET MODULE D'IMAGERIE ÉQUIPÉ DE CELUI-CI

(30) Priority: 27.03.2015 JP 2015067248
(43) Date of publication of application: 31.01.2018
(73) Proprietor: Kyocera Corporation, Kyoto-shi Kyoto 6128501 (JP)
(72) Inventor: WATANABE, Shinji, Kyoto-shi Kyoto 612-8501 (JP)
(74) Representative: Viering, Jentschura & Partner mbB Patent- und Rechtsanwälte
(86) International application number: PCT/JP2016/055575
(87) International publication number: WO 2016/158109

(56) References cited:
- WO-A1-2006/129762
- WO-A1-2014/054353
- JP-A- H06 326 214
- JP-A- H06 326 214
- JP-A- 2000 208 665
- JP-A- 2010 267 944
- US-A1- 2006 202 318

## Description

### Technical Field

The present disclosure relates to an imaging component and an imaging module provided with the same.

### Background Art

As an imaging component, for example, there is known a camera module described in Japanese Unexamined Patent Publication JP-A 2004-104078 (also referred to as Patent Literature 1, hereinafter). The camera module described in Patent Literature 1 includes: a flexible sheet; and an imaging element mounted on a surface of the flexible sheet.

US 2014/159203 A1 discloses a substrate pad structure comprising a first pad protruding over a top surface of a package substrate, wherein the first pad is of a first elongated shape, a second pad embedded in the package substrate, wherein the second pad is of a second elongated shape and a via coupled between the first pad and the second pad.

WO 2006/129762 A1 discloses a semiconductor image sensor module and a method for preparing the same, wherein the semiconductor image sensor module is provided by stacking a first semiconductor chip, which has an image sensor wherein a plurality of pixels composed of a photoelectric conversion element and a transistor are arranged, and a second semiconductor chip, which has an A/D converter array.

WO 2014/054353 A1 discloses an electronic component-embedded module with a multilayer substrate including a first resin layer having a plurality of first pattern conductors and a space, and a second resin layer having a second pattern conductor and a plurality of third pattern conductors, wherein the second pattern conductor may be arranged around a first pad with a gap, and the second resin layer is present between the second pattern conductor and at least one of the first pads.

### Citation List

### Patent Literature

Patent Literature 1: Japanese Unexamined Patent Publication JP-A 2004-104078

### Summary of Invention

The invention provides an imaging component according to claim 1. Preferred embodiments are described in the dependent claims.

### Brief Description of Drawings

FIG. 1 is a sectional view showing an imaging component and an imaging module;
FIG. 2 is a schematic diagram showing a situation of a surface of a laminated substrate in an imaging component shown in FIG. 1;
FIG. 3 is a schematic diagram showing wiring shapes of conductor patterns in an imaging component shown in FIG. 1;
FIG. 4 is a partial transparent plan view showing an electrode pad and a conductor pattern;
FIG. 5 is a partial transparent plan view showing electrode pads, first portions of conductor patterns, and a laminated substrate;
FIG. 6 is a partial transparent plan view showing an electrode pad and a conductor pattern;
FIG. 7 is a partial transparent plan view showing an electrode pad and a conductor pattern; and
FIG. 8 is a partial transparent plan view showing an electrode pad and a conductor pattern.

### Description of Embodiments

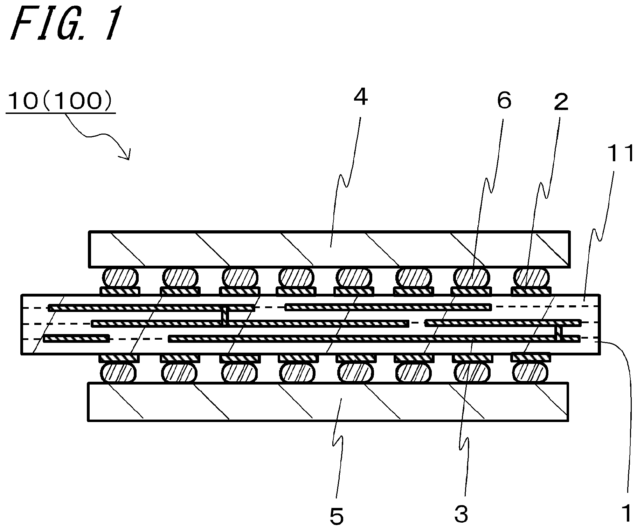

Hereinafter, an imaging component 10 is described below with reference to the drawings. As shown in FIG. 1, the imaging component 10 includes: a laminated substrate 1; electrode pads 2 disposed on an upper face of the laminated substrate 1; and conductor patterns 3 disposed between layers of the laminated substrate 1 and electrically connected to the electrode pads 2. Further, an imaging module 100 includes: the imaging component 10; and an imaging element 4 mounted on the electrode pads 2 of the imaging component 10.

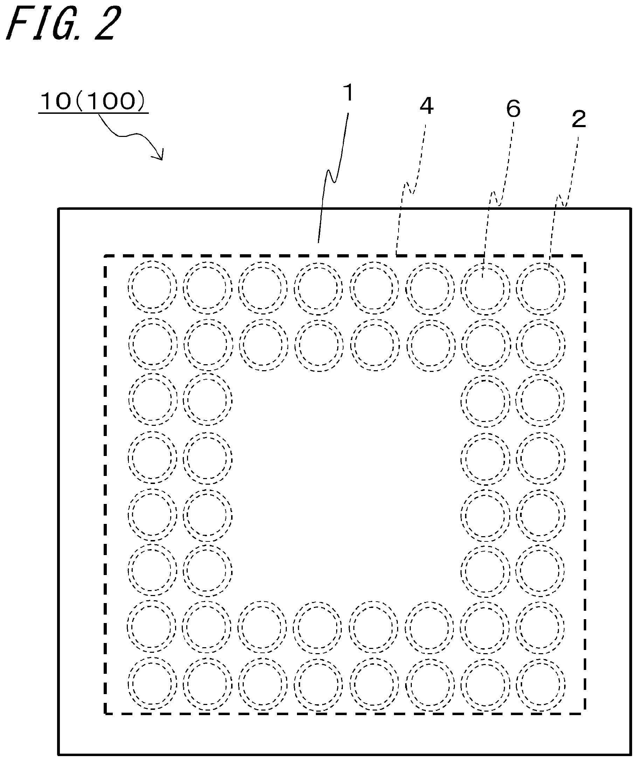

The laminated substrate 1 is formed of a resin material. For example, as the resin material, an epoxy resin is used. Here, the above-mentioned expression "formed of a resin material" does not necessarily indicate that the laminated substrate is formed of a resin material alone. That is, any other material may be contained. Specifically, a so-called glass epoxy which is constituted such that glass fibers are impregnated with an epoxy resin, or the like may be employed. For example, the laminated substrate 1 may be prepared by laminating glass epoxy substrates. As shown in FIG. 2, for example, the laminated substrate 1 has a quadrangular-shaped principal surface and is formed in a plat-like shape. As for the dimensions of the laminated substrate 1, for example, in a case where the laminated substrate 1 has a quadrangular shape, the vertical dimension can be set to 15 to 20 mm, the horizontal dimension can be set to 15 to 20 mm, and the thickness can be set to 0.5 to 2 mm. More specifically, the laminated substrate 1 includes a plurality of layers 11. For example, the thickness of each of the plurality of layers 11 is 0.05 to 0.2 mm.

The electrode pad 2 is a member used for mounting the imaging element 4 on the laminated substrate 1. The plural electrode pads 2 are disposed on the upper face of the laminated substrate 1. As shown in FIGS. 1 and 2, for example, the electrode pad 2 has a rectangular shape in a sectional view and a circular shape in a plan view. Here, FIG. 2 depicts the situation of the surface of the laminated substrate 1 in a state where the imaging element 4, the electrode pads 2, and solder balls 6 are made as if transparent.

For example, the electrode pad 2 is formed of a metallic material such as copper or gold. As for the dimensions of the electrode pad 2, for example, in a case where the electrode pad 2 has a circular shape in a plan view, the diameter can be set to 0.1 to 1 mm and the thickness can be set to 0.01 to 0.05 mm. For example, as the method for mounting the imaging element 4, a ball grid array or otherwise can be adopted. As shown in FIG. 1, in the imaging component 10 of the present disclosure, the imaging element 4 is mounted by a ball grid array and hence a plurality of solder balls 6 are disposed between a lower face of the imaging element 4 and an upper face of the electrode pads 2.

The conductor pattern 3 is a member for transmitting a signal generated by the imaging element 4 mounted on the electrode pads 2, to another electronic component 5 such as a monitor. The conductor pattern 3 is a belt-shaped member. The conductor pattern 3 is disposed between the layers of the laminated substrate 1. For example, the conductor pattern 3 is formed of a metallic material such as copper or gold.

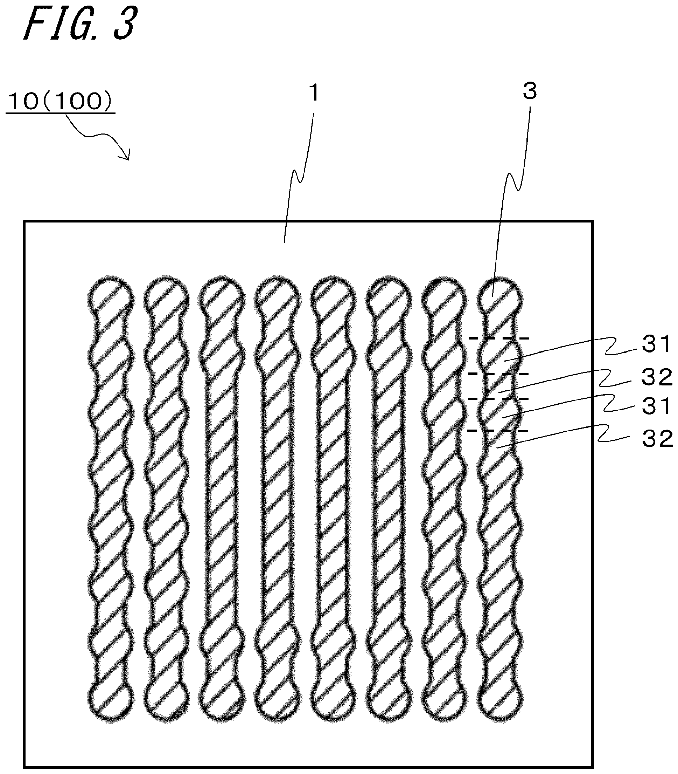

Here, in the imaging component 10 of the present disclosure, as shown in FIGS. 2 and 3, a part of at least one of conductor patterns 3 has a widened portion 31, the widened portion 31 being located immediately below any of electrode pads 2 which are not connected to the at least one of conductor patterns. Here, the above-mentioned "widened portion" indicates a portion whose width is widened partly in the conductor pattern 3 extending with a fixed width. Specifically, as shown in FIG. 3, in a case where the conductor pattern 3 extends in a belt shape, imaginary lines perpendicular to an extension direction of the conductor pattern 3 are drawn at a location where the width of the conductor pattern 3 begins to change when viewed in the extension direction of the conductor pattern 3 and at a location where the width change ends. Then, a region of the conductor pattern 3 located between the two imaginary lines is regarded as the widened portion 31.

In other words, the imaging component 10 includes: the laminated substrate 1 constituted such that the plurality of layers 11 formed of a resin material are laminated; the plurality of electrode pads 2 disposed on the surface of the laminated substrate 1; and the plurality of conductor patterns 3 disposed between the plurality of layers 11. The plurality of conductor patterns 3 have belt shapes. At least one of the plurality of conductor patterns 3 has a first portion 31 and a second portion 32. The first portion 31 overlaps with one of the plurality of electrode pads 2 in a stacking direction of the plurality of layers 11. The second portion 32 does not overlap with the plurality of electrode pads 2 in the stacking direction. The width of the first portion 31 is greater than the width of the second portion 32. The conductor patterns 3 may be formed by printing onto the surfaces of the plurality of layers 11 is performed at the time of lamination of the plurality of layers 11.

Here, in the conductor patterns 3 shown in FIG. 3, for simplicity of understanding, each conductor pattern 3 is intentionally simplified into a straight line shape. The conductor pattern 3 may be formed in a complicated shape. Thus, although FIGS. 2 and 3 are in correspondence to each other, the arrangement of the conductor patterns 3 in FIG. 1 and the arrangement of the conductor patterns 3 in FIG. 3 are not strictly in correspondence to each other. Further, the above-mentioned expression "any of electrode pads 2 which are not connected to the at least one of conductor patterns" does not indicate that the electrode pad 2 and the conductor pattern 3 are completely isolated electrically from each other. Specifically, the expression excludes merely a case where the widened portion 31 of the conductor pattern 3 and the electrode pad 2 located immediately thereabove are directly connected by a through hole or the like. That is, the widened portion 31 and the electrode pad 2 may be indirectly connected through a common power supply or a common ground.

When the portion of the conductor pattern 3 located immediately below the electrode pad 2 has the widened portion 31 as described above, it is possible to reduce a situation that the portion of the laminated substrate 1 immediately below the electrode pad 2 sinks. Further, when in a region other than the portion of the conductor pattern 3 located immediately below the electrode pad 2, the width is made narrower than that of the portion located immediately below the electrode pad 2, high-density routing of the conductor patterns 3 is possible. As a result, the imaging component 10 can be obtained in which the conductor patterns 3 are routed at a high density and yet degradation in the positional accuracy of the imaging element 4 is reduced.

Here, in a transparent plane view, the outer shape of the widened portion 31 may be the same as the outer shape of the electrode pad 2. In other words, when viewed from a direction perpendicular to the surface of the laminated substrate 1, the outer shape of the first portion 31 may, in embodiments not forming part of the invention as claimed, be the same as the outer shape of the electrode pad 2 overlapping with the first portion 31. When such a configuration is employed, it is possible to reduce unevenness in the stress in the surface of the conductor pattern 3 transmitted from the electrode pad 2. Then, this can reduce deformation caused in the imaging component 10.

Here, the above-mentioned expression "the shape is the same" indicates that the shape of the portion of the outer shape of the widened portion 31 in directions other than the extension direction of the conductor pattern 3 is the same as the outer shape of the electrode pad. For example, in FIG. 3, the shape of the portion of the outer shape of the widened portion 31 in directions other than the extension direction of the conductor pattern 3 may be regarded as a circular shape. Then, as shown in FIG. 2, the electrode pad 2 has a circular shape. That is, in the present disclosure, the widened portion 31 and the electrode pad 2 are of the same shape.

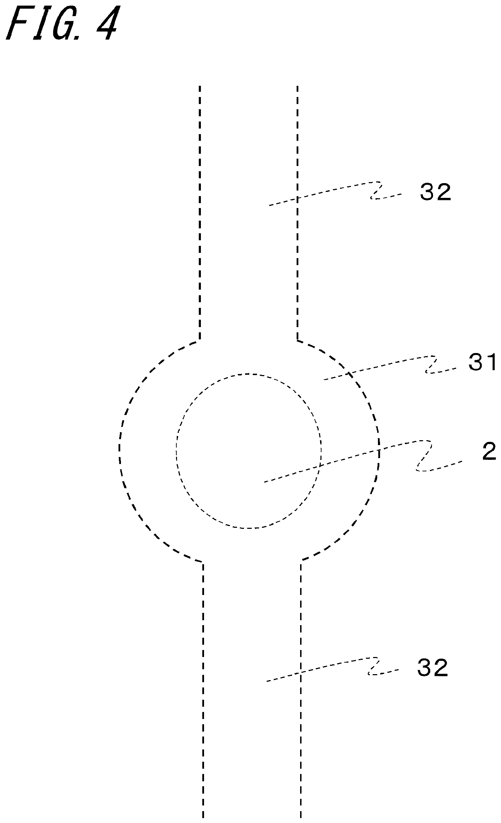

According to the present invention, as shown in FIG. 4, the widened portion 31 of the conductor pattern 3 is wider than the electrode pad 2. In other words, when viewed from the direction perpendicular to the surface of the laminated substrate 1, the first portion 31 is wider than the electrode pad 2 overlapping with the first portion 31. By virtue of this, even when the deviation in the positional relation between the electrode pad 2 and the conductor pattern 3 is caused under heat cycles, the conductor pattern 3 can be located immediately below the electrode pad 2. More specifically, for example, in a case where the electrode pad 2 has a circular shape in a plan view, it is sufficient that the wide portion of the conductor pattern 3 is formed in a circular shape larger than the electrode pad 2.

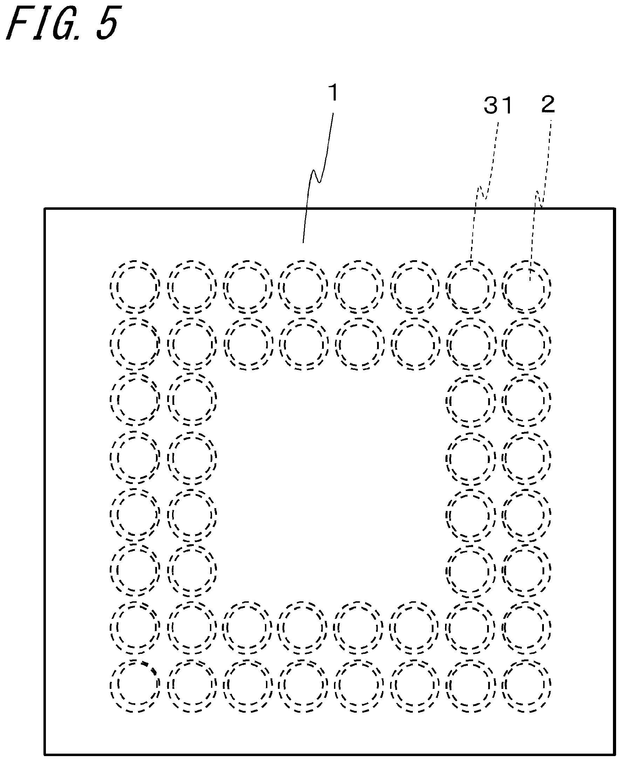

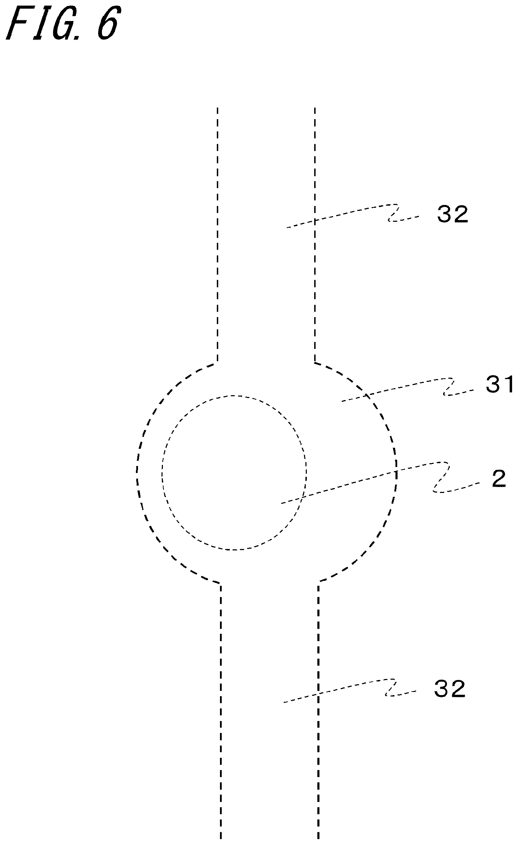

Further, as shown in FIGS. 5 and 6, when viewed from the direction perpendicular to the surface of the laminated substrate 1, the first portion 31 is, in accordance with the invention, wider than the electrode pad 2 overlapping with the first portion 31, and the centroid of each first portion 31 may be located more distant from the centroid of the laminated substrate 1 than from the centroid of each electrode pad 2 overlapping with the first portion 31. In FIG. 5, for simplicity of understanding, the first portions 31 alone of the conductor pattern 3 are shown. More specifically, the centroid of the first portion 31 may be located on an extension line of a straight line joining the centroid of the laminated substrate 1 and the centroid of the electrode pad 2.

Under heat cycles, larger thermal expansion and larger thermal contraction are caused in the surface than in the inside of the laminated substrate 1. In a case where the width of the first portion 31 is made larger than the width of the electrode pad 2 and the centroid thereof is deviated to the outer side of the laminated substrate 1, the electrode pad 2 can easily overlap with the first portion 31 even when the position of the electrode pad 2 deviates under heat cycles.

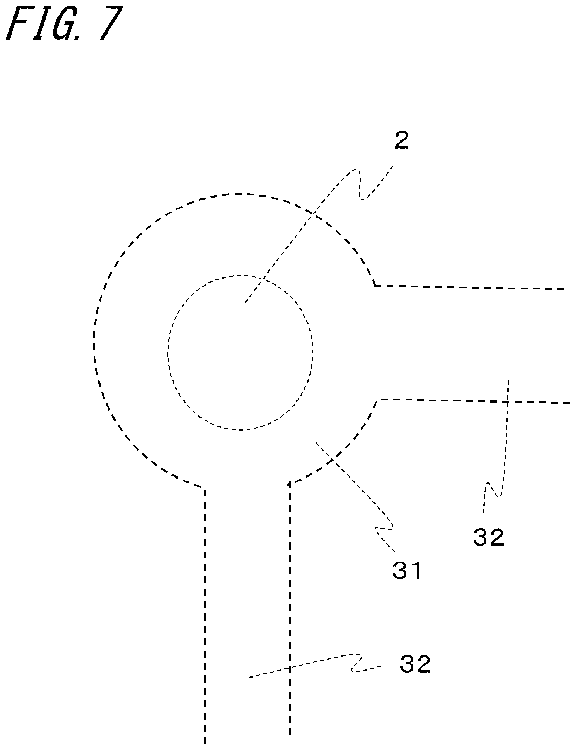

Further, as shown in FIG. 7, the first portion 31 may be located in a bent portion of the conductor pattern 3. In other words, the width of the conductor pattern 3 may be larger in the bent portion of the conductor pattern 3. In general, the bent portion of the conductor pattern 3 is susceptible to a thermal stress from other portions. Specifically, in the straight line portion of the conductor pattern 3, thermal expansion in the length direction is mainly caused. In contrast, the bent portion of the conductor pattern 3 receives a thermal stress from the two straight line portions adjacent to the bent portion. Thus, the direction of occurrence of thermal expansion is difficult to be controlled. Here, as shown in FIG. 7, when the first portion 31 is located in the bent portion of the conductor pattern 3, thermal expansion in the bent portion itself can be made larger. By virtue of this, it is possible to reduce a possibility that a thermal stress caused by thermal expansion of other portions results in thermal expansion of the first portion 31 in an unpredictable direction. This can improve the reliability in the imaging component 10 under heat cycles.

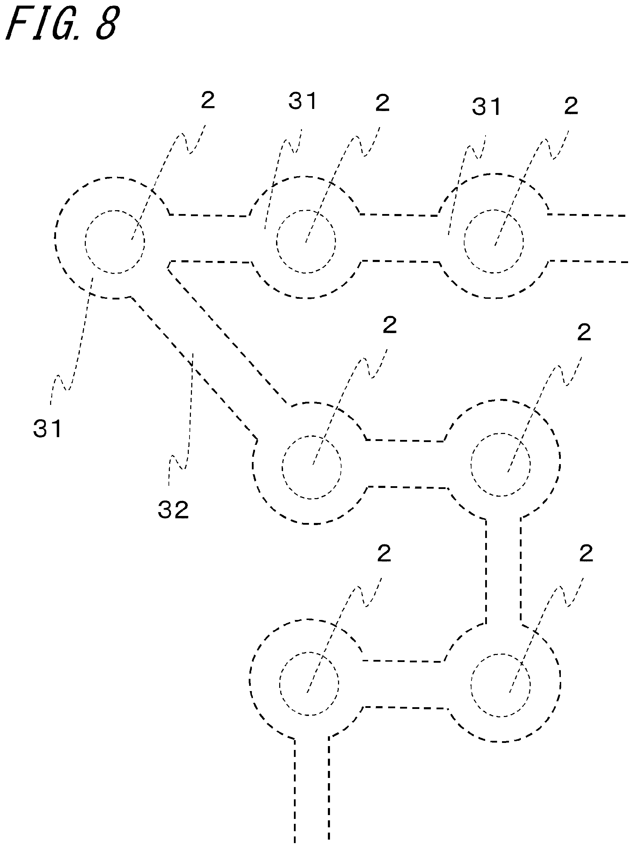

Further, as shown in FIG. 8, adjacent first portions 31 may be arranged at equal intervals. When the first portions 31 are arranged at equal intervals, it is possible to reduce a possibility of unevenness in the thermal expansion amount caused in the laminated substrate 1 under heat cycles. This can reduce a possibility of distortion in the laminated substrate 1.

### Reference Signs List

- 1:: Laminated substrate
- 11:: Layer
- 2:: Electrode pad
- 3:: Conductor pattern
- 31:: Widened portion
- 4:: Imaging element
- 5:: Electronic component
- 10:: Imaging component
- 100:: Imaging module

## Claims

1. An imaging component (10), comprising:
a laminated substrate (1) constituted such that a plurality of layers (11) formed of a resin material are laminated;
a plurality of electrode pads (2) disposed on a surface of the laminated substrate (1); and
a plurality of conductor patterns (3) disposed between the plurality of layers (11),
the plurality of conductor patterns (3) having belt shapes, at least one of the plurality of conductor patterns (3) having a first portion (31) and a second portion (32), the first portion (31) overlapping with one of the plurality of electrode pads (2) in a stacking direction of the plurality of layers (11), the second portion (32) not overlapping with the plurality of electrode pads (2) in the stacking direction, a width of the first portion (31) being greater than a width of the second portion (32);
wherein when viewed from a direction perpendicular to the surface, the first portion (31) is wider than the one of the plurality of electrode pads (2) overlapping with the first portion (31).

2. The imaging component (10) according to claim 1,
wherein when viewed from a direction perpendicular to the surface, an outer shape of the first portion (31) is a same as an outer shape of the one of the plurality of electrode pads (2) overlapping with the first portion (31).

3. The imaging component (10) according to claim 1, wherein when viewed from a direction perpendicular to the surface, a centroid of the first portion (31) is located more distant from a centroid of the laminated substrate (1) than from a centroid of the one of the plurality of electrode pads (2) overlapping with the first portion (31).

4. An imaging module (100), comprising:
the imaging component (10) according to any one of claims 1 to 3; and
an imaging element (4) mounted on the plurality of electrode pads (2) of the imaging component (10).

## Patentansprüche

1. Abbildungskomponente (10), aufweisend:
ein laminiertes Substrat (1), das derart ausgebildet ist, dass eine Mehrzahl von Schichten (11), die aus einem Harzmaterial gebildet sind, laminiert sind,
eine Mehrzahl von Elektrodenpads (2), die auf einer Fläche des laminierten Substrats (1) angeordnet sind, und
eine Mehrzahl von Leitermustern (3), die zwischen der Mehrzahl von Schichten (11) angeordnet sind,
wobei die Mehrzahl von Leitermustern (3) Bandformen hat, wobei mindestens eines aus der Mehrzahl von Leitermustern (3) einen ersten Abschnitt (31) und einen zweiten Abschnitt (32) aufweist, wobei der erste Abschnitt (31) in einer Stapelrichtung der Mehrzahl von Schichten (11) mit einem aus der Mehrzahl von Elektrodenpads (2) überlappt ist, wobei der zweite Abschnitt (32) in der Stapelrichtung nicht mit der Mehrzahl von Elektrodenpads (2) überlappt ist, wobei eine Breite des ersten Abschnitts (31) größer als eine Breite des zweiten Abschnitts (32) ist,
wobei bei Betrachtung aus einer Richtung senkrecht zu der Fläche der erste Abschnitt (31) breiter als das eine aus der Mehrzahl von Elektrodenpads (2) ist, das mit dem ersten Abschnitt (31) überlappt ist.

2. Abbildungskomponente (10) gemäß Anspruch 1,
wobei bei Betrachtung aus einer Richtung senkrecht zu der Fläche eine äußere Form des ersten Abschnitts (31) gleich wie eine äußere Form des einen aus der Mehrzahl von Elektrodenpads (2) ist, das mit dem ersten Abschnitt (31) überlappt ist.

3. Abbildungskomponente (10) gemäß Anspruch 1, wobei bei Betrachtung aus einer Richtung senkrecht zu der Fläche ein Schwerpunkt des ersten Abschnitts (31) weiter entfernt von einem Schwerpunkt des laminierten Substrats (1) als von einem Schwerpunkt des einen aus der Mehrzahl von Elektrodenpads (2) angeordnet ist, das mit dem ersten Abschnitt (31) überlappt ist.

4. Abbildungsmodul (100), aufweisend:
die Abbildungskomponente (10) gemäß irgendeinem der Ansprüche 1 bis 3 und
ein Abbildungselement (4), das auf der Mehrzahl von Elektrodenpads (2) der Abbildungskomponente (10) montiert ist.

## Revendications

1. Composant d'imagerie (10), comprenant :
un substrat stratifié (1) constitué de telle sorte qu'une pluralité de couches (11) formées d'un matériau de résine sont stratifiées ;
une pluralité de plots d'électrode (2) disposés sur une surface du substrat stratifié (1) ; et
une pluralité de motifs conducteurs (3) disposés entre la pluralité de couches (11),
la pluralité de motifs conducteurs (3) ayant des formes de bande, au moins l'un de la pluralité de motifs conducteurs (3) ayant une première partie (31) et une seconde partie (32), la première partie (31) chevauchant l'un de la pluralité de plots d'électrode (2) dans une direction d'empilement de la pluralité de couches (11), la seconde partie (32) ne chevauchant pas la pluralité de plots d'électrode (2) dans la direction d'empilement, une largeur de la première partie (31) étant supérieure à une largeur de la seconde partie (32) ;
dans lequel, lors d'une vue depuis une direction perpendiculaire à la surface, la première partie (31) est plus large que celui de la pluralité de plots d'électrode (2) chevauchant la première partie (31).

2. Composant d'imagerie (10) selon la revendication 1,
dans lequel, lors d'une vue depuis une direction perpendiculaire à la surface, une forme extérieure de la première partie (31) est la même qu'une forme extérieure de l'un de la pluralité de plots d'électrode (2) chevauchant la première partie (31).

3. Composant d'imagerie (10) selon la revendication 1, dans lequel, lors d'une vue depuis une direction perpendiculaire à la surface, un centroïde de la première partie (31) est situé plus loin d'un centroïde du substrat stratifié (1) que d'un centroïde de l'un de la pluralité de plots d'électrode (2) chevauchant la première partie (31).

4. Module d'imagerie (100), comprenant :
le composant d'imagerie (10) selon l'une quelconque des revendications 1 à 3 ; et
un élément d'imagerie (4) monté sur la pluralité de plots d'électrode (2) du composant d'imagerie (10).
